# FASCICULE DE BREVET EUROPEEN

(11) **EP 2 774 000 B1**
(45) Date de publication et mention de la délivrance du brevet: **06.09.2017**
(21) Numéro de dépôt: 12795496.4
(22) Date de dépôt: 30.10.2012
(51) Int. Cl.: G03F 7/11, G03F 7/20

(54) **PROCEDE ANTI-EFFETS DE CHARGE POUR LA LITHOGRAPHIE ET LA MICROSCOPIE ELECTRONIQUE**
VERFAHREN ZUR VERMEIDUNG VON AUFLADUNGSEFFEKTEN FÜR DIE LITHOGRAPHIE UND ELEKTRONENMIKROSKOPIE
METHOD FOR AVOIDING CHARGE EFFECTS FOR LITHOGRAPHY AND ELECTRON MICROSCOPY

(30) Priorité: 02.11.2011 FR 1159890
(43) Date de publication de la demande: 10.09.2014
(73) Titulaire: Université Paris-Sud 11, 91400 Orsay (FR); Centre National de la Recherche Scientifique, 75016 Paris (FR)
(72) Inventeur: AASSIME, Abdelhanin, F-91310 Monthlery (FR); PALOMO, José, F-75020 Paris (FR); HAMOUDA, Frédéric, F-91600 Savigny sur Orge (FR)
(74) Mandataire: Pontet Allano & Associes
(86) Numéro de dépôt international: PCT/FR2012/052520
(87) Numéro de publication internationale: WO 2013/064782

(56) Documents cités:
- DYLEWICZ R ET AL: "Charge dissipation layer based on conductive polymer for electron-beam patterning of bulk zinc oxide", ELECTRONIC LETTERS, THE INSTITUTION OF ENGINEERING AND TECHNOLOGY, vol. 46, no. 14, 8 juillet 2010 (2010-07-08), pages 1025-1026, XP006036679, ISSN: 1350-911X, DOI: 10.1049/EL:20101282

## Description

La présente invention concerne un procédé de traitement appliqué à des matériaux isolants qui a pour but d'éviter ou de limiter les effets de charge se produisant sur ces matériaux lorsqu'ils sont exposés à un faisceau électronique. Elle concerne également un système comprenant des moyens agencés pour mettre en oeuvre un tel procédé.

L'invention est applicable pour traiter des matériaux plus ou moins isolants soumis à un faisceau d'électrons de façon générale, et plus particulièrement pour la lithographie électronique des résines sur des substrats isolants et pour l'observation par microscopie électronique à balayage de motifs isolants et/ou de résine sur tous types de substrats.

### Etat de la technique

Le caractère plus ou moins isolant de certains substrats et de nombres de résines et de motifs isolants peut causer des difficultés lors de leur irradiation par un faisceau d'électrons, que ce soit par exemple pour l'écriture électronique en lithographie, ou pour l'observation par microscopie électronique à balayage. En effet, une partie des électrons du faisceau est piégée par le substrat isolant ou la résine et crée de ce fait un champ électrique qui dévie les électrons incidents. Cette déviation peut entraîner, dans le cas de l'écriture électronique directe, des erreurs de positionnement des motifs sur le substrat isolant, ou, dans le cas de l'observation, une distorsion dans l'image obtenue. Ces difficultés peuvent être gênantes pour la fiabilité et la précision, et peuvent constituer un facteur limitant pour l'amélioration des résolutions.

Pour remédier à ce problème, un procédé consistant à couvrir l'échantillon d'une fine couche conductrice pour augmenter sa conductivité est utilisé. En particulier, il est d'usage de déposer une fine couche conductrice d'une épaisseur de quelques nm, sur le substrat isolant ou la résine.

Cette technique est utilisable aussi bien pour la lithographie à faisceau d'électrons que pour la microscopie électronique à balayage.

Pour la lithographie, la fine couche conductrice déposée peut être de deux types :
- une couche métallique qui peut être placée soit sous la résine, soit au-dessus de la résine.
- Une résine conductrice (Exemple de l'ESPACER 300 commercialisé par la société Denko Showa), à placer sur le substrat isolant ou la résine, qui présente l'avantage d'être soluble dans l'eau.

Mais ces techniques présentent des inconvénients. Dans le cas d'une couche métallique, l'utilisation d'une solution chimique pour l'éliminer est nécessaire et peut entrainer une altération de l'échantillon. Concernant les résines conductrices, ce sont des solutions chimiques corrosives et toxiques, qui ne sont pas compatibles avec tous les types de support. De plus, leurs conditions de stockage et d'utilisation sont très contraignantes pour des raisons de sécurité, ce qui entraîne des complexités et des coûts supplémentaires.

Pour l'observation par microscopie électronique, une fine couche métallique est déposée sur les matériaux isolants. Mais cette technique peut être considérée comme destructrice pour l'échantillon puisqu'elle en change la nature, ou parce qu'il faudrait là aussi une solution corrosive pour la retirer.

Un but de l'invention est de pallier les inconvénients de l'état de la technique.

Plus particulièrement, un but de l'invention est de proposer une méthode non destructrice pour l'échantillon qui soit moins contraignante à mettre en oeuvre, tout en visant une annulation ou une limitation des effets de charge, et en particulier :
- une annulation ou une diminution des erreurs de positionnement des motifs sur le substrat,
- un meilleur réglage lors de la mise au point du faisceau électronique sur l'échantillon.

### Exposé de l'invention

L'invention propose d'atteindre au moins l'un de ces buts par un procédé de traitement pour éviter ou limiter les effets de charge sur un support formé par un substrat isolant ou une résine et destiné à être soumis à une irradiation électronique, caractérisé en ce qu'il comprend les étapes suivantes :
- dépôt d'une couche sacrificielle non conductrice sur le substrat ou la résine,
- dépôt d'une couche conductrice sur la couche sacrificielle,
- irradiation électronique pour lithographie ou observation,
- élimination de la couche sacrificielle et de la couche conductrice.

L'invention propose donc de réaliser le dépôt d'une bicouche de matériaux distincts sur un support formé par un substrat isolant ou une résine. Un intérêt que présente la couche sacrificielle est son élimination possible par un moyen simple sans entrainer d'altération de l'échantillon, et que son élimination entraîne également celle de la couche conductrice supérieure. C'est donc un moyen simple, non contraignant et non destructeur pour l'échantillon pour diminuer les effets de charge lors de l'irradiation par le faisceau d'électrons.

Cette méthode peut être avantageuse en particulier pour deux types d'utilisations :
a) la lithographie électronique sur matériaux isolants,
b) l'observation par microscopie électronique à balayage de matériaux isolants.

Le dépôt de la bicouche peut être réalisé par des procédés connus, par exemple un procédé de type PVD (« Physical Vapor Deposition »).

Dans le cas de la lithographie électronique, la bicouche est déposée sur le substrat isolant recouvert de résine, puis après insolation, la bicouche est éliminée en solubilisant la couche sacrificielle dans un bain approprié.

Dans le cas de l'observation, la bicouche est déposée sur le matériau isolant avant son observation par microscopie électronique à balayage. Après observation, la bicouche est éliminée par solubilisation de la couche sacrificielle. Dans le cas particulier où le matériau isolant est une résine, l'avantage que présente cette technique est de laisser la résine intacte pour pouvoir ensuite en faire une autre utilisation. Un autre avantage est la possibilité d'utiliser tous types de substrats, isolants ou non, ce qui apporte souplesse et homogénéité des processus.

Selon l'invention, la couche sacrificielle peut être constituée d'oxyde de molybdène ou d'oxyde de germanium, pur ou en concentration majoritaire.

Dans le cas où la couche sacrificielle est constituée majoritairement de :
- oxyde de molybdène, l'étape d'élimination de la couche sacrificielle peut être réalisée avec de l'eau,
- oxyde de germanium, l'agent d'élimination peut être du peroxyde d'hydrogène.

L'élimination de la couche sacrificielle peut se réaliser de la température ambiante. Pour faciliter l'élimination de la couche sacrificielle par l'eau lorsque la couche sacrificielle est particulièrement fine (< 10 nm), il peut être utile d'augmenter la température de dissolution, par exemple jusqu'à 40 °C.

Selon l'invention, la couche conductrice peut être majoritairement, voire exclusivement, constituée d'un métal, par exemple le molybdène, l'or, l'argent, le carbone ou l'aluminium.

Avantageusement, la couche sacrificielle et la couche métallique sont majoritairement, voire exclusivement, formées à partir d'un même métal de base.

Selon un exemple de réalisation préféré, la couche sacrificielle est majoritairement constituée d'oxyde de molybdène et la couche métallique majoritairement de molybdène. L'oxyde de molybdène présente l'avantage d'être éliminable à l'eau.

Selon un autre mode de réalisation, couche sacrificielle et couche métallique peuvent être confondues en une seule couche majoritairement voire exclusivement constituée de molybdène éliminable au peroxyde d'hydrogène.

Des modes de réalisation variés de l'invention sont prévus, intégrant selon l'ensemble de leurs combinaisons possibles les différentes caractéristiques optionnelles exposées ici.

### Liste des figures

D'autres particularités et avantages de l'invention ressortiront de la description détaillée d'un mode de mise en oeuvre nullement limitatif, et des dessins annexés sur lesquels :
- la Figure 1 est une représentation sous la forme d'un diagramme d'un exemple de mise en oeuvre du procédé selon l'invention.

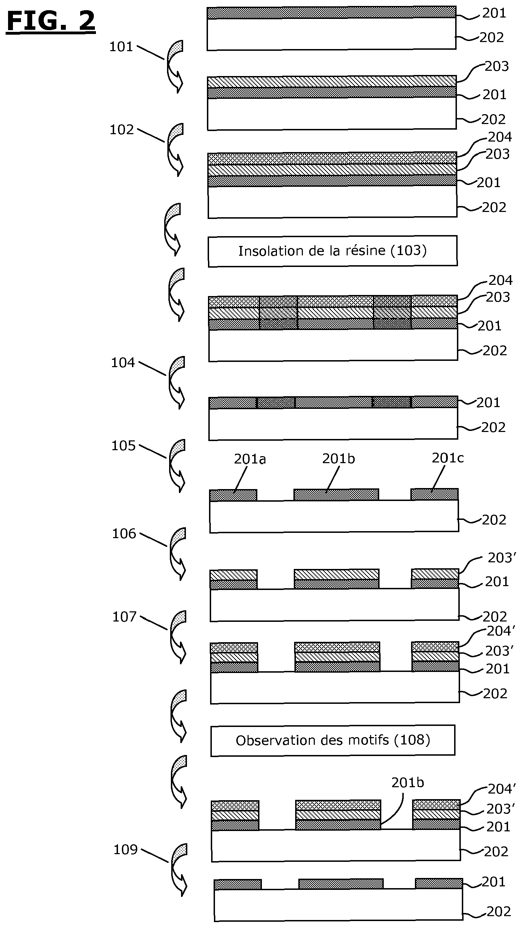

- la Figure 2 est une représentation schématique, selon une vue en coupe non à l'échelle, de différentes étapes d'un exemple de mise en oeuvre du procédé selon l'invention.
- la Figure 3 est une photo d'un exemple d'observation à deux échelles différentes de motifs en résine obtenus selon le procédé présenté en exemple dans la Figure 1.
- la Figure 4 est un exemple de résultat obtenu sur un substrat de verre lithographié selon le procédé présenté en exemple dans la Figure 1.

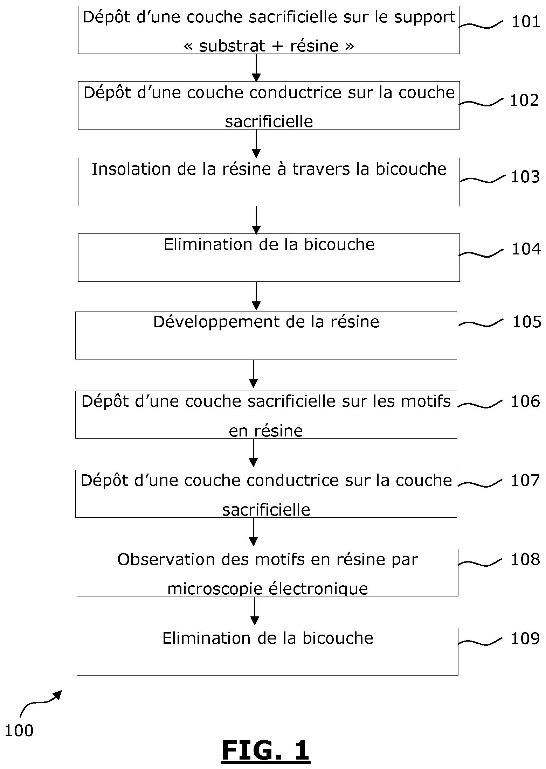

Le procédé 100 représenté sur la Figure 1 comprend une étape 101 de dépôt par un procédé PVD d'une couche sacrificielle 203 constituée d'oxyde de molybdène, sur un support constitué d'un substrat isolant 202 en verre recouvert d'une couche de résine PMMA 201 (polyméthacrylate de méthyle). L'épaisseur de la couche sacrificielle 203 peut être comprise typiquement entre 3 et 30 nm et de préférence entre 5 et 20 nm.

Cette étape 101 est suivie d'une étape 102 de dépôt d'une couche conductrice 204 en molybdène par un procédé PVD. L'épaisseur de la couche conductrice peut être comprise typiquement entre 3 et 30 nm et de préférence entre 3 et 20 nm.

Une fois la bicouche 203, 204 déposée sur le support 202, la résine 201 est insolée à l'étape 103 à travers la bicouche en intercalant un masque pour définir les zones à exposer au faisceau électronique.

A l'étape 104, la bicouche est éliminée à l'eau, pour pouvoir développer la résine 201 à l'étape 105.

A ce stade, on voit que le procédé a déjà permis de réaliser la partie électronique 103 de la lithographie en présence de la couche conductrice 204, et donc avec une meilleure précision.

L'étape 106 est à nouveau une étape de dépôt d'une couche sacrificielle 203', mais cette fois-ci sur les motifs en résine obtenus 201a à 201c. Cette couche sacrificielle 203' d'une épaisseur de 5 nm est de l'oxyde de molybdène.

Sur cette couche d'oxyde de molybdène, est déposée à l'étape 107 une couche conductrice 204' d'une épaisseur de 5 nm constituée de métal. Ce métal peut être du molybdène, qui présente alors l'avantage d'une bonne compatibilité avec la couche sacrificielle. La couche conductrice 204' peut aussi être faite d'or, qui présente l'avantage d'être meilleur conducteur que le molybdène.

A l'étape 108, les motifs en résine 201a à 201c sont observés par microscopie électronique à balayage en présence de la couche conductrice 204', permettant ainsi une amélioration de la qualité de l'image obtenue.

A l'étape 109, la bicouche est dissoute dans l'eau.

A ce stade, l'échantillon est débarrassé de la bicouche 203', 204', et donc prêt à être utilisé, ce qui rend bien non destructive l'étape précédente 108 d'observation.

Par exemple, cette observation 108 peut être utilisée sur un état intermédiaire sans interférer avec le processus global de fabrication. Il est alors possible de continuer un processus de fabrication, par exemple avec un dépôt de nouvelles couches suivi de nouvelles étapes de lithographie.

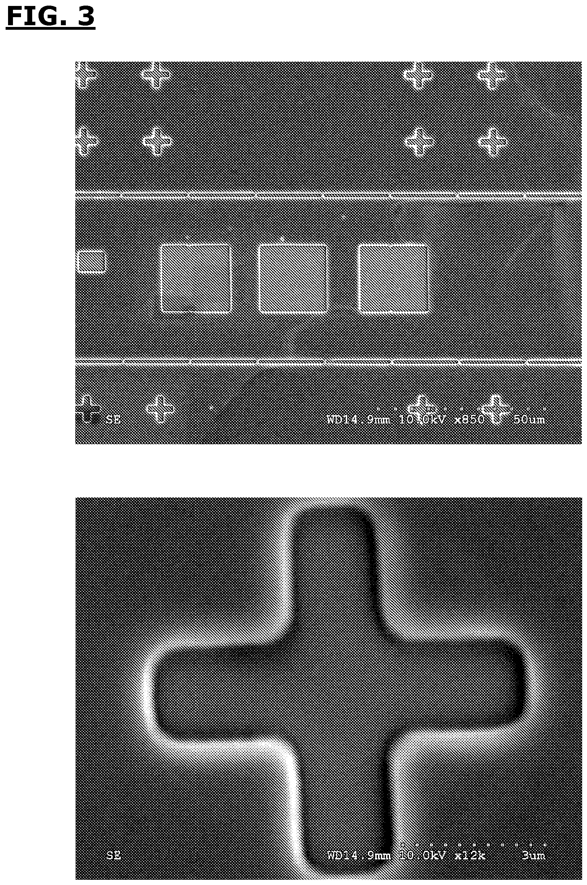

La figure 3 est un exemple d'observation de motifs en résine obtenus selon le procédé 100, lors de l'étape d'observation 108. Un intérêt de la bicouche repose sur le fait que les motifs en résine sont ensuite « réutilisables » car non altérés par l'élimination de la bicouche.

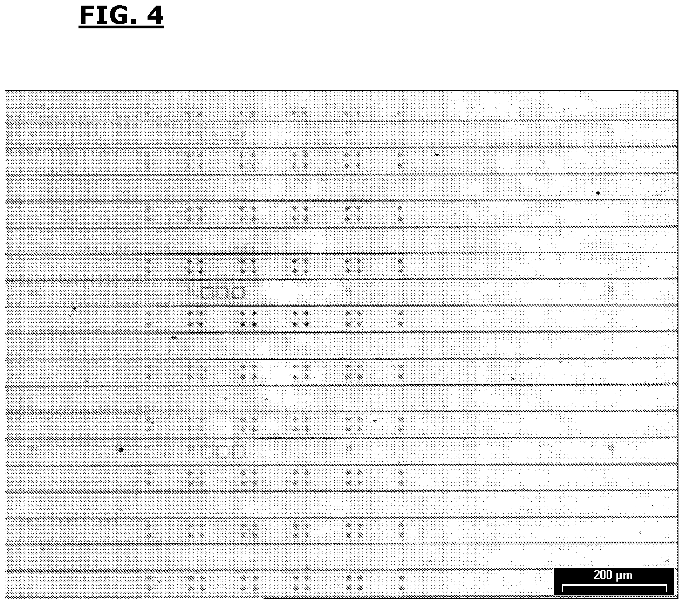

La figure 4 est une image au microscope optique d'un échantillon en verre lithographié après préparation des motifs en résine selon le procédé 100.

Bien sûr, l'invention n'est pas limitée aux exemples qui viennent d'être décrits et de nombreux aménagements peuvent être apportés à ces exemples sans sortir du cadre de l'invention.

## Revendications

1. Procédé de traitement (100) pour éviter ou limiter les effets de charge sur un support formé par un substrat isolant ou une résine et destiné à être soumis à une irradiation électronique, **caractérisé en ce qu'**il comprend :
- une étape de dépôt (101) d'une couche sacrificielle (203, 203') non conductrice,
- une étape de dépôt (102) d'une couche conductrice (204, 204') sur ladite couche sacrificielle (203, 203'), lesdites couche sacrificielle et couche conductrice étant constituées de deux matériaux distincts,
- une étape d'irradiation électronique (103),
- une étape d'élimination(104) de la couche sacrificielle (203, 203').

2. Procédé selon la revendication 1, **caractérisé en ce que** la couche sacrificielle (203, 203') est majoritairement constituée d'oxyde de molybdène.

3. Procédé selon la revendication 2, **caractérisé en ce que** la couche sacrificielle (203, 203') est éliminée à l'eau.

4. Procédé selon la revendication 3 **caractérisé en ce que** l'étape d'élimination (104, 109) de la couche sacrificielle (203, 203') est réalisée à une température comprise entre 25 et 40°C.

5. Procédé selon la revendication 1, **caractérisé en ce que** la couche sacrificielle (203, 203') est majoritairement constituée d'oxyde de germanium.

6. Procédé selon l'une quelconque des revendications 2 à 4, **caractérisé en ce que** la couche sacrificielle (203, 203') est éliminée au peroxyde d'hydrogène.

7. Procédé selon l'une quelconque des revendications précédentes, **caractérisé en ce que** la couche conductrice (204, 204') est majoritairement constituée de métal.

8. Procédé selon l'une quelconque des revendications précédentes, **caractérisé en ce que** la couche sacrificielle (203, 203') et la couche conductrice (204, 204') sont majoritairement formées à partir d'un même métal de base.

9. Procédé selon l'une quelconque des revendications précédentes, **caractérisé en ce que** la couche sacrificielle (203, 203') est de l'oxyde de molybdène éliminable à l'eau et la couche conductrice (204, 204') est majoritairement constituée de molybdène.

10. Système comprenant des moyens agencés pour mettre en oeuvre le procédé (100) selon l'une quelconque des revendications 1 à 9.

## Patentansprüche

1. Behandlungsverfahren (100) zur Vermeidung oder Begrenzung der Aufladungseffekte auf einem von einem isolierenden Substrat oder einem Harz gebildeten Träger, dazu bestimmt, einer elektronischen Strahlung unterworfen zu werden, **dadurch gekennzeichnet, dass** es umfasst:
- einen Schritt zur Auftragung (101) einer nicht leitfähigen Opferschicht (203, 203'),
- einen Schritt zur Auftragung (102) einer leitfähigen Schicht (204, 204') auf der Opferschicht (203, 203'), wobei die Opferschicht und die leitfähige Schicht aus zwei verschiedenen Materialien bestehen,
- einen Schritt zur elektronischen Bestrahlung (103),
- einen Schritt zur Abtragung (104) der Opferschicht (203, 203').

2. Verfahren nach Anspruch 1, **dadurch gekennzeichnet, dass** die Opferschicht (203, 203') mehrheitlich aus Molybdänoxid besteht.

3. Verfahren nach Anspruch 2, **dadurch gekennzeichnet, dass** die Opferschicht (203, 203') mit Wasser abgetragen wird.

4. Verfahren nach Anspruch 3, **dadurch gekennzeichnet, dass** der Schritt zur Abtragung (104, 109) der Opferschicht (203, 204') bei einer Temperatur zwischen 25 und 40°C erfolgt.

5. Verfahren nach Anspruch 1, **dadurch gekennzeichnet, dass** die Opferschicht (203, 203') mehrheitlich aus Germaniumoxid besteht.

6. Verfahren nach einem der Ansprüche 2 bis 4, **dadurch gekennzeichnet, dass** die Opferschicht (203, 203') mittels Wasserstoffperoxid abgetragen wird.

7. Verfahren nach einem der vorhergehenden Ansprüche, **dadurch gekennzeichnet, dass** die leitfähige Schicht (204, 204') mehrheitlich aus Metall besteht.

8. Verfahren nach einem der vorhergehenden Ansprüche, **dadurch gekennzeichnet, dass** die Opferschicht (203, 203') und die leitfähige Schicht (204, 204') mehrheitlich aus einem gleichen Grundmetall ausgebildet sind.

9. Verfahren nach einem der vorhergehenden Ansprüche, **dadurch gekennzeichnet, dass** die Opferschicht (203, 203') mittels Wasser entfernbares Molybdänoxid ist und dass die leitfähige Schicht (204, 204') mehrheitlich aus Molybdän besteht.

10. System mit Mitteln, welche zur Umsetzung des Verfahrens (100) nach einem der Ansprüche 1 bis 9 angeordnet sind.

## Claims

1. Method of treatment (100) for avoiding or limiting the charging effects on a support formed by an insulating substrate or a resin and intended to be subjected to electron irradiation, **characterized in that** it comprises:
- a step of depositing (101) a non-conductive sacrificial layer (203, 203'),
- a step of depositing (102) a conductive layer (204, 204') on said sacrificial layer (203, 203'), said sacrificial layer and conductive layer being constituted by two different materials,
- a step of electron irradiation (103),
- a step of eliminating (104) the sacrificial layer (203, 203').

2. Method according to claim 1, **characterized in that** the sacrificial layer (203, 203') is mainly constituted by molybdenum oxide.

3. Method according to claim 2, **characterized in that** the sacrificial layer (203, 203') is eliminated with water.

4. Method according to claim 3, **characterized in that** the step of eliminating (104, 109) the sacrificial layer (203, 203') is carried out at a temperature comprised between 25 and 40°C.

5. Method according to claim 1, **characterized in that** the sacrificial layer (203, 203') is mainly constituted by germanium oxide.

6. Method according to any one of claims 2 to 4, **characterized in that** the sacrificial layer (203, 203') is eliminated with hydrogen peroxide.

7. Method according to any one of the preceding claims, **characterized in that** the conductive layer (204, 204') is mainly constituted by metal.

8. Method according to any one of the preceding claims, **characterized in that** the sacrificial layer (203, 203') and the conductive layer (204, 204') are mainly formed from one and the same base metal.

9. Method according to any one of the preceding claims, **characterized in that** the sacrificial layer (203, 203') is molybdenum oxide that can be eliminated with water and the conductive layer (204, 204') is mainly constituted by molybdenum.

10. System comprising means arranged for implementing the method (100) according to any one of claims 1 to 9.
